# EUROPÄISCHE PATENTSCHRIFT

(11) **EP 0 433 596 B1**
(45) Veröffentlichungstag und Bekanntmachung des Hinweises auf die Patenterteilung: **04.01.1995**
(21) Anmeldenummer: 90119826.7
(22) Anmeldetag: 16.10.1990
(51) Int. Cl.: H04H 1/00

(54) **Verfahren und Anordnung zur Unterdrückung von unerwünschten automatischen Senderwechseln**
Method and apparatus for suppressing undesired automatic transmitter change-over
Procédé et dispositif pour supprimer les changements automatiques d'émetteur non souhaités

(30) Priorität: 17.11.1989 DE 3938268
(43) Veröffentlichungstag der Anmeldung: 26.06.1991
(73) Patentinhaber: GRUNDIG E.M.V. Elektro-Mechanische Versuchsanstalt Max Grundig holländ. Stiftung & Co. KG., D-90762 Fürth (DE)
(72) Erfinder: Nohse, Dieter, GRUNDIG E.M.V., Kurgartenstrasse 37, W-8510 Fuerth (DE); Kagerbauer, Gottfried, GRUNDIG E.M.V., Kurgartenstrasse 37, W-8510 Fuerth (DE)

(56) Entgegenhaltungen:
- EP-A- 0 201 681
- EP-A- 0 211 366
- EP-A- 0 275 527
- GB-A- 2 068 668

## Beschreibung

Die Erfindung betrifft ein Verfahren und eine Anordnung zur Vermeidung von unerwünschten, automatischen Senderwechseln in mobilen Rundfunkempfangsgeräten.

Senderwechsel Werden oft automatisch vorgenommen, wenn die Empfangsqualität des eingestellten Senders nicht mehr ausreichend ist. Insbesondere im Verkehrsfunk-Modus wird bei Abfall der Empfangsqualität eines eingestellten Verkehrsfunksenders unter einen vorgegebenen Schwellwert ein Sendersuchlauf gestartet, um einen stärker einfallenden Verkehrsfunksender einzustellen. Ein solches Rundfunkempfangsgerät wird in der deutschen Offenlegungsschrift DE-OS 34 16 917 beschrieben, wobei hier die Empfangsqualität nach jeder Verkehrsdurchsage überprüft wird, und bei geringer Empfangsqualität eine neue Abstimmung auf einen besser empfangbaren Sender vorgenommen wird.

Bei solchen Empfängern ist es weiter bekannt, daß akustische Warnsignale ausgegeben werden, wenn im Verkehrsfunkmodus kein Verkehrsfunksender in ausreichender Qualität empfangbar ist.

Bei Rundfunkempfängern, die Datensignale nach dem Radio-Daten-System (RDS) verarbeiten können, ist es weiterhin bekannt, daß vor dem Einleiten des Sendersuchlaufs noch die alternativen Frequenzen (AF's), das sind Abstimmfrequenzen, die zur gleichen Programm- oder Senderkette wie der eingestellte Sender gehören, daraufhin überprüft werden, ob eine solche Frequenz mit ausreichender Qualität empfangbar ist. Erst wenn dies nicht der Fall ist wird ein Suchlauf begonnen.

Bei den bekannten Vorgehensweisen wird jedoch auch bei vorübergehenden Störungen ein Suchlauf begonnen und unter Umständen ein anderes Programm angewählt, obwohl das ursprünglich eingestellte Programm nach kurzer Zeit wieder gut zu empfangen ist und somit der Wechsel nicht notwendig und seitens des Benutzers unerwünscht ist.

Aufgabe der Erfindung ist es deshalb, unerwünschte Programmwechsel sowie Warnsignale bei Störungen, die das gesamte Frequenzband betreffen, zu vermeiden.

Störungen des gesamten Frequenzbandes treten bei Autoradioempfängern vor allem auf, Wenn man durch ein Tunnel fährt, oder wenn man sich in einer Tiefgarage befindet.

Um bei solchen Störungen einen unerwünschten Sendersuchlauf und/oder beim Verkehrsfunk einen Warnton zu unterdrücken, wird vor dem Starten des Sendersuchlaufs, d.h. des Suchlaufs der zum Auffinden und Einstellen eines Senders dient, zunächst ein schneller, für den Benutzer unmerkbarer Suchlauf, gestartet. Dieser schnelle Suchlauf vollzieht sich unhörbar und dient lediglich zur Feststellung, ob überhaupt ein Sender empfangen werden kann. Eine Sendereinstellung, d.h. Zuordnung der Empfangsqualität zu einer Frequenz, ist bei dem schnellen Suchlauf nicht möglich und die Überprüfung der Empfangsqualität beschränkt sich nur auf ein Qualitätsmerkmal, wie z.B. Empfangsfeldstärke. Liegt die Empfangsqualität im gesamten Frequenzband unter einer vorgegebenen Grenze, dann wird der momentane Abstimmzustand für eine bestimmte Zeit beibehalten und ein Sendersuchlauf sowie ein Warnton im Verkehrsfunkmodus unterdrückt. Der schnelle, unmerkbare Suchlauf mit Rückkehr auf den Ausgangszustand wird solange zyklisch wiederholt, bis wieder Sender zu empfangen sind.

Figur 1 zeigt ein Beispiel für den zeitlichen Verlauf der Abstimmspannung (a), der Empfangsqualität (b) und des Steuersignals für die Stummschaltung (c).

Figur 2 zeigt eine Anordnung zur Durchführung des erfindungsgemäßen Verfahrens.

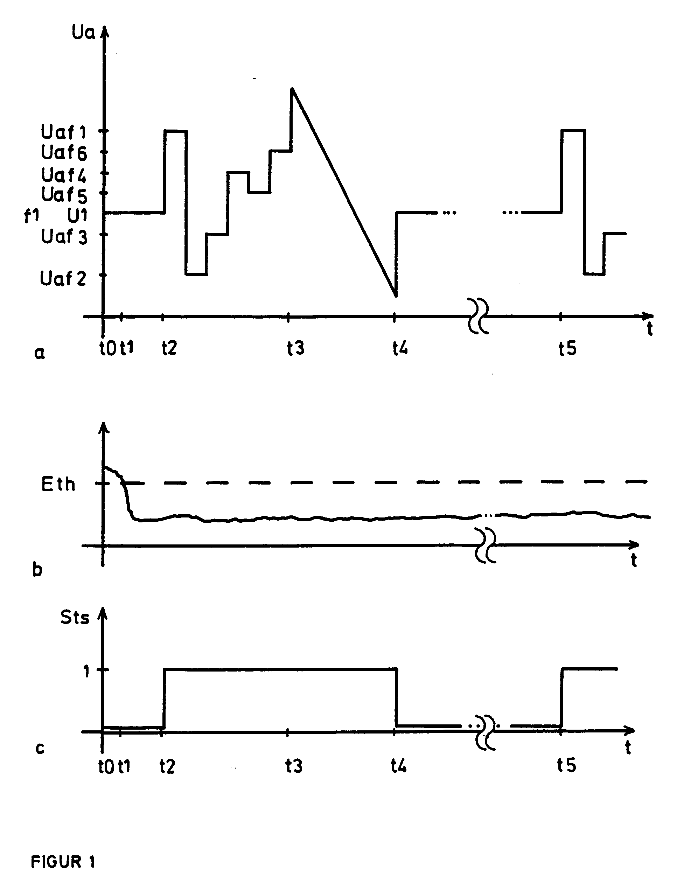

Für die Empfangsqualität ist in Figur 1 als Beispiel die Empfangsfeldstärke über die gesamte Zeitachse angegeben. Die Empfangsqualität kann ebenso durch andere Kriterien bestimmt werden, wie z.B. Störungen durch Mehrwegeempfang, RDS-Fehlerrate usw., bzw. aus einer Kombination der einzelnen Qualitätsmerkmale. Lediglich beim schnellen Suchlauf wird die Überprüfung der Empfangsqualität auf ein Qualitätsmerkmal eingeschränkt.

Zum Zeitpunkt tₒ ist ein Sender der Frequenz f₁ mit der Abstimmspannung U₁ eingestellt, der mit ausreichender Qualität empfangen wird. Zum Zeitpunkt t₁ sinkt die Empfangsqualität unter einen vorgegebenen Schwellwert. Mit kurzer zeitlicher Verzögerung wird dann zum Zeitpunkt t₂ ein Steuersignal Sts für Stummschaltung ausgegeben und es werden die im Speicher abgelegten alternativen Frequenzen überprüft. Im dargestellten Fall werden bis zum Zeitpunkt t₃ sechs alternative Frequenzen mit den Abstimmspannungen Uaf₁ bis Uaf₆ überprüft. Geht man von dem Fall aus, daß man sich mit seinem Auto an einem Ort befindet, an dem kein Empfang bzw. keine ausreichende Empfangsqualität möglich ist, wie dies in der Regel in einem Tunnel oder einer Tiefgarage der Fall ist, bleibt die Emfangsqualität in Fig. 1b bis zum Zeitpunkt t₃ unter dem Schwellwert Eₜₕ. Bei dem erfindungsgemäßen Verfahren wird an dieser Stelle kein normaler Suchlauf mit Stop bei empfangswürdigen Sendern gestartet, der vergeblich wäre und gegebenenfalls zu einem Warnton führen würde, sondern es Wird ein schneller, unmerkbarer Suchlauf, von sehr kurzer Dauer, über das gesamte Frequenzband gestartet. Dazu nimmt die Abstimmspannung ihren höchsten Wert an und fällt linear bis zum niedrigsten Wert ab, der Zum Zeitpunkt t₄ erreicht wird. Der lineare Abfall der Abstimmspannung sei hier nur beispielhaft dargestellt und kann ebensogut durch einen Anstieg oder Abfall mit veränderlicher Steigung ersetzt werden.

Wenn im Zeitraum t₃ bis t₄ die Empfangsqualität den Schwellwert Eₜₕ nicht erreicht oder überschreitet, wird zum Zeitpunkt t₄ die ursprünglich eingestellte Abstimmspannung U₁ wieder eingestellt und das Steuersignal Sts schaltet die Stummschaltung gemäß Fig. 1c wieder aus.

Für eine vorbestimmte Zeitdauer bleibt jetzt der Sender auf der Frequenz f₁ eingestellt. Wenn die Empfangsqualität während dieses Zeitraums den Schwellwert Eₜₕ nicht überschreitet wird zum Zeitpunkt t₅ wieder mit der Stummschaltung und der Überprüfung der alternativen Frequenzen begonnen.

Eine vorteilhafte Weiterbildung dieser Vorgehensweise besteht darin, daß im Zeitraum t₄ bis t₅ die Empfangsqualität mit einem zweiten, niedrigeren Schwellwert verglichen wird und daß bei Unterschreiten dieses Schwellwertes die Stummschaltung mit dem Steuersignal Sts aktiviert wird. Auf diese Weise wird die Wiedergabe eines stark gestörten Programms verhindert.

Eine weitere vorteilhafte Ausgestaltung der Erfindung liegt darin, daß beim Einschalten des Autoradios, d.h. beim Einschalten durch den Ein-/-Ausschalter des Radios und ebenso beim automatischen Einschalten des Radios mit dem Einschalten der Zündung, der Zeitraum t₄ bis t₅ länger dauert, da man in diesem Fall davon ausgeht, daß man sich in einer Tiefgarage befindet und das Verlassen dieser Tiefgarage länger dauert.

Eine weitere Ausgestaltung der Erfindung ergibt sich, wenn man zum Zeitpunkt t₅ sofort mit dem schnellen unmerkbaren Suchlauf beginnt, ohne vorher die alternativen Frequenzen zu überprüfen.

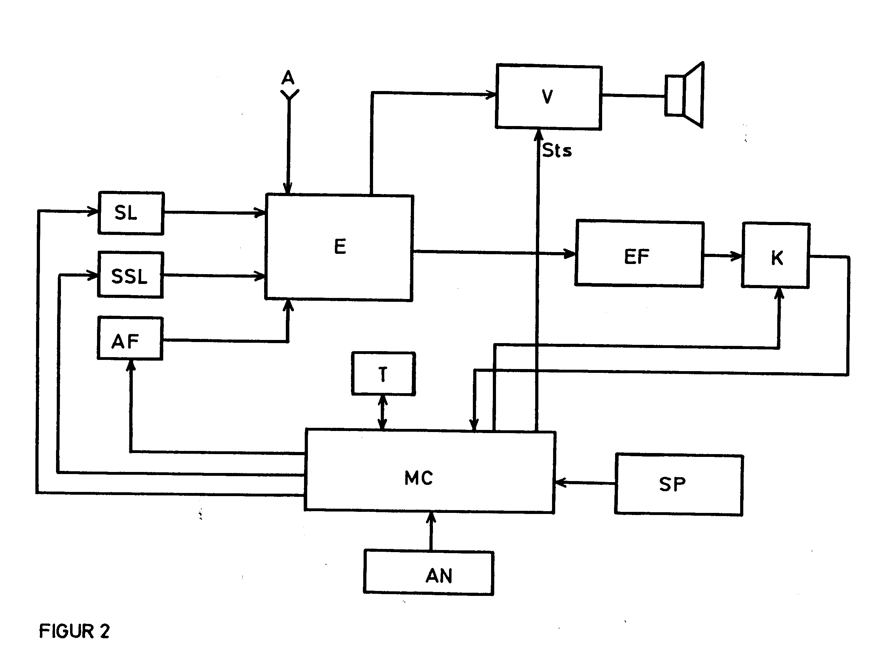

Zur Erläuterung der Ausführung des beschriebenen Verfahrens ist in Fig. 2 ein Blockschaltbild angegeben, das die folgenden Funktionsblöcke umfaßt:

Die Mikrocomputereinheit MC steuert den Ablauf des erfindungsgemäßen Verfahrens und ist verbunden mit der Anzeigeeinheit AN, die eine optische oder eine akustische Anzeige sein kann. Weiterhin ist der Mikrocomputer MC mit dem Speicher SP verbunden, der die Abstimmdaten für die alternativen Frequenzen enthält, und mit den Funktionseinheiten AF, SSL und SL. Die Einheit AF steuert die Überprüfung der alternativen Frequenzen, während die Einheiten SSL und SL den schnellen, unmerkbaren und den Sendersuchlauf steuern, wobei die Ausgangssignale dieser Einheiten zum Empfangsteil E führen und dieses abstimmen. Das in diesem Empfangsteil empfangene Signal wird im Verstärker V, der vom Mikrocomputer MC gesteuert wird, wobei im Blockschaltbild nur die für die Erfindung wichtige Steuersignalleitung Sts für die Stummschaltung enthalten ist, verstärkt. Die Empfangsqualität wird im Funktionsblock EF festgestellt und ein entsprechendes Signal an den Komparator K gegeben, in dem es mit dem Schwellwert Eₜₕ verglichen wird. Das Vergleichsergebnis wird im Mikrocomputer im Sinne des erfindungsgemäßen Verfahrens ausgewertet.

Ein Timerblock T, der mit dem Mikrocomputer MC verbunden ist und von diesem seine Anfangs- und Endzeit als Vorgabe erhält, steuert die Zeitdauer zwischen den Zeitpunkten t₄ und t₅.

Es sei noch erwähnt, daß das Blockschaltbild nach Fig. 2 nur die erfindungswesentlichen Funktionsblöcke und Verbindungen enthält, und daß einzelne Funktionsblöcke sowohl hardwaremäßig, als auch durch ein Mikrocomputerprogramm ausgeführt sein können.

## Patentansprüche

1. Verfahren zur Unterdrückung von unerwünschten, automatischen Senderwechseln in mobilen Rundfunkempfangsgeräten, welche Signale nach dem Radio-Daten-System (RDS) verarbeiten können,
**dadurch gekennzeichnet**, daß
a) bei Abfall der Empfangsqualität eines eingestellten RDS-Senders unter einen vorgegebenen ersten Schwellwert zunächst alle gespeicherten alternativen Frequenzen auf ihre Empfangsqualität überprüft werden, und
b) dann, wenn keine alternative Frequenz mit ausreichender Qualität empfangbar ist, ein schneller Suchlauf gestartet wird, der über das gesamte Frequenzband geht und überprüft, ob überhaupt ein Sender empfangbar ist, und
c) dann, wenn kein Sender empfangbar ist, der zuletzt empfangene Sender wieder eingestellt wird und für eine vorgegebene Zeitdauer eingestellt bleibt, ohne daß ein Sendersuchlauf gestartet wird, und
d) die Verfahrensschritte a) bis c) zyklisch wiederholt werden, bis wieder Sender empfangbar sind.

2. Verfahren zur Unterdrückung von unerwünschten, automatischen Senderwechseln in mobilen Rundfunkempfangsgeräten, welche Signale nach dem Radio-Daten-System (RDS) verarbeiten können,
**dadurch gekennzeichnet**, daß
a) bei Abfall der Empfangsqualität eines eingestellten RDS-Senders unter einen vorgegebenen ersten Schwellwert zunächst alle gespeicherten alternativen Frequenzen auf ihre Empfangsqualität überprüft werden und dann, wenn keine alternative Frequenz mit ausreichender Qualität empfangbar ist,
b) ein schneller Suchlauf gestartet wird, der über das gesamte Frequenzband geht und überprüft, ob überhaupt ein Sender empfangbar ist, und
c) dann, wenn kein Sender empfangbar ist, der zuletzt empfangene Sender wieder eingestellt wird und für eine vorgegebene Zeitdauer eingestellt bleibt, ohne daß ein Sendersuchlauf gestartet wird, und
d) die Verfahrensschritte b) bis c) zyklisch wiederholt werden, bis wieder Sender empfangbar sind.

3. Verfahren nach Anspruch 1 oder 2, **dadurch gekennzeichnet**, daß die Zeitdauer, für die der zuletzt empfangene Sender nach dem schnellen Suchlauf eingestellt wurde, davon abhängt, ob der Empfänger längere Zeit im Betrieb war oder erst eingeschaltet wurde.

4. Verfahren nach einem oder mehreren der Ansprüche 1 bis 3, **dadurch gekennzeichnet**, daß während des schnellen Suchlaufs das Empfangsgerät stummgeschaltet Wird.

5. Verfahren nach einem oder mehreren der Ansprüche 1 bis 4, **dadurch gekennzeichnet**, daß die Empfangsqualität des in nicht ausreichender Qualität eingestellten Senders mit einem zweiten Schwellwert verglichen wird, und daß das Empfangsgerät stummgeschaltet wird, wenn die festgestellte Empfangsqualität unter dem Zweiten Schwellwert liegt.

6. Anordnung zur Durchführung des Verfahrens nach den Ansprüchen 1 bis 5, gekennzeichnet durch folgende Funktionsblöcke
- ein Empfängerteil (E), welches die von einer Antenne (A) empfangenen Signale verarbeitet und seine Ausgangssignale über einen Verstärker (V) an einen Lautsprecher gibt,
- einen Funktionsblock (EF), der die Empfangsqualität des im Empfängerteil (E) empfangenen Signals bewertet und ein der Empfangsqualität entsprechendes Signal an einen Komparator (K) leitet, in dem es mit einem von einem Mikrocomputer (MC) vorgegeben Schwellensignal verglichen wird und das Vergleichsergebnis zur Auswertung an den Mikrocomputer (MC) zurückgeführt wird,
- einen Speicher (SP), in dem eine Liste von alternativen Frequenzen, die den gleichen Programminhalt wie der eingestellte Sender haben, abgelegt ist,
- Abstimmblöcke zum Abstimmen der alternativen Frequenzen (AF), zur Steuerung des Sendersuchlaufes (SL) und zur Steuerung des schnellen Suchlaufes (SSL), und
- ein Timer (T), der mit dem Mikrocomputer verbunden ist und der die Zeitdauer vorgibt, welche zwischen dem schnellen Suchlauf und dem Start des nächsten schnellen Suchlaufs bzw. der Überprüfung der alternativen Frequenzen vergeht.

## Claims

1. Method of suppressing undesirable automatic station changes in mobile radio receivers which are capable of processing signals in accordance with the radio data system (RDS), characterized in that
a) if the reception quality of a set RDS station drops below a specified first threshold value, all the stored alternative frequencies are first checked for their reception quality, and
b) if no alternative frequency is receivable with adequate quality, a fast search is started which traverses the entire frequency band and checks whether any station at all is receivable, and
c) if no station is receivable, the station received last is again set and remains set for a specified time without a station search being started, and
d) the steps a) to c) in the method are cyclically repeated until stations are again receivable.

2. Method of suppressing undesirable automatic station changes in mobile radio receivers which are capable of processing signals in accordance with the radio data system (RDS), characterized in that
a) if the reception quality of a set RDS station drops below a specified first threshold value, all the stored alternative frequencies are first checked for their reception quality and if no alternative frequency is receivable with adequate quality,
b) a fast search is started which traverses the entire frequency band and checks whether any station at all is receivable, and
c) if no station is receivable, the station last received is set again and remains set for a specified time without a station search being started, and
d) the steps b) to c) in the method are cyclically repeated until stations are receivable again.

3. Method according to Claim 1 or 2, characterized in that the time for which the station last received was set after the fast search depends on whether the receiver had been in operation for a fairly long time or had just been switched on.

4. Method according to one or more of Claims 1 to 3, characterized in that the receiver is muted during the fast search.

5. Method according to one or more of Claims 1 to 4, characterized in that the reception quality of the station set with inadequate quality is compared with a second threshold value and in that the receiver is muted if the reception quality found is below the second threshold value.

6. Device for carrying out the method according to Claims 1 to 5, characterized by the following functional blocks
- a receiver section (E) which processes signals received from an aerial (A) and passes its output signals via an amplifier (V) to a loudspeaker,
- a functional block (EF) which assesses the reception quality of the signal received in the receiver section (E) and feeds a signal corresponding to the reception quality to a comparator (K) in which the signal is compared with a threshold signal specified by a microcomputer (MC), and the comparison result is fed back to the microcomputer (MC) for evaluation,
- a memory (SP) in which a list of alternative frequencies is stored, which frequencies have the same programme content as the set station,
- tuning blocks for tuning the alternative frequencies (AF), for controlling the station search (SL) and for controlling the fast search (SSL), and
- a timer (T) which is connected to the microcomputer and which sets the time which elapses between the fast search and the start of the next fast search or the checking of the alternative frequencies.

## Revendications

1. Procédé pour supprimer un changement automatique non désiré d'émetteur dans des appareils mobiles de réception radio qui peuvent traiter des signaux d'après le système de données radio (RDS)
caractérisé en ce que
a) lors d'une baisse de la qualité de réception d'un émetteur RDS sélectionné, en dessous d'une première valeur prédéterminée de seuil, toutes les autres fréquences stockées en mémoire sont d'abord vérifiées quand à leur qualité de réception, et
b) ensuite, si aucune autre fréquence ne peut être reçue avec une qualité satisfaisante, un processus de recherche rapide est lancé qui s'étend sur toute la bande de fréquences et vérifie si au moins un émetteur peut être reçu, et
c) ensuite, si aucun émetteur ne peut être reçu, l'émetteur reçu immédiatement auparavant est de nouveau sélectionné et reste sélectionné pendant une durée prédéterminée sans qu'un processus de recherche d'émetteur soit lancé, et
d) les étapes du procédé de a) jusqu'à c) sont répétées de manière cyclique jusqu'à ce que des émetteurs puissent de nouveau être reçus.

2. Procédé pour supprimer un changement automatique non désiré d'émetteur dans des appareils mobiles de réception radio qui peuvent traiter des signaux d'après le système de données radio (RDS)
caractérisé en ce que
a) lors d'une baisse de la qualité de réception d'un émetteur RDS sélectionné, en dessous d'une première valeur prédéterminée de seuil, toutes les autres fréquences stockées en mémoire sont d'abord vérifiées quand à leur qualité de réception, et alors si aucune autre fréquence ne peut être reçue avec une qualité satisfaisante,
b) un processus de recherche rapide est déclenché qui s'étend sur toute la gamme de fréquences et vérifie si au moins un émetteur peut être reçu, et
c) ensuite, si aucun émetteur ne peut être reçu, l'émetteur reçu immédiatement auparavant est de nouveau sélectionné et reste sélectionné pendant une durée prédéterminée sans qu'un processus de recherche d'émetteur soit lancé, et
d) les étapes du procédé b) et c) sont répétées de manière cyclique jusqu'à ce que des émetteurs puissent de nouveau être reçus.

3. Procédé selon la revendication 1 ou 2, caractérisé en ce que la durée, pendant laquelle le dernier émetteur reçu est sélectionné après le processus de recherche rapide, dépend du fait que le récepteur était en service depuis un certain temps ou venait d'être mis en service.

4. Procédé d'après une ou plusieurs des revendications 1 à 3, caractérisé en ce que pendant le processus de recherche rapide l'appareil de réception est commuté en accord silencieux.

5. Procédé d'après une ou plusieurs des revendications 1 à 4, caractérisé en ce que la qualité de réception de l'émetteur sélectionné avec une qualité insuffisante est comparée avec une deuxième valeur de seuil, et que l'appareil de réception est commuté en accord silencieux si cette qualité de réception est déterminée se trouver inférieure à la deuxième valeur de seuil.

6. Configuration pour la mise en oeuvre du procédé selon les revendications 1 à 5, caractérisée par les blocs fonctionnels suivants :
- un module de réception (E) qui traite des signaux reçus par une antenne (A) et transmet ses signaux de sortie par l'intermédiaire d'un amplificateur (V) à un haut-parleur,
- un bloc fonctionnel (EF) qui évalue la qualité de réception du signal reçu dans le module de réception (E) et envoie un signal correspondant à la qualité de réception à un comparateur (K) dans lequel il est comparé par un microcalculateur (MC) à un signal prédéterminé de seuil et le résultat de la comparaison est renvoyé au microcalculateur pour évaluation.
- une mémoire (SP) dans laquelle est stockée une liste d'autres fréquences qui ont le même contenu de programmes que l'émetteur sélectionné,
- des blocs d'accord pour accorder sur les autres fréquences (AF), pour commander le processus de recherche d'émetteur (SL) et pour commander le processus de recherche rapide (SSL), et
- un temporisateur (T) qui est relié au microcalculateur et qui détermine la durée de temps qui s'écoule entre le processus de recherche rapide et le début du processus suivant de recherche rapide ou la vérification des autres fréquences.
